# EUROPÄISCHE PATENTANMELDUNG

(11) **EP 1 179 846 A2**
(43) Veröffentlichungstag der Anmeldung: **13.02.2002**
(21) Anmeldenummer: 01117912.4
(22) Anmeldetag: 24.07.2001
(51) Int. Cl.: H01L 23/48, H01L 23/051, H01L 21/50, H01L 23/10

(54) **Gehäuse für ein elektronisches Bauelement**

(30) Priorität: 10.08.2000 DE 10038999
(71) Anmelder: ROBERT BOSCH GMBH, 70442 Stuttgart (DE)
(72) Erfinder: Lucas, Bernhard, 74354 Besigheim (DE); Kugler, Andreas, 73553 Alfdorf (DE)

(57) **Zusammenfassung**

Es wird ein Gehäuse für ein elektronisches Bauelement (1), insbesondere ein Gunn-Element zur Erzeugung von Radarwellen, vorgeschlagen, das ein Bodenteil (3, 11), ein Wandteil (4) aus insbesondere mittels Spritzguss verarbeitbarem Kunststoff und ein Deckelbauteil (22) umfasst, die das elektronische Bauelement (1) im Einbauzustand umschließen. Das Deckelbauteil (22) weist weiter eine Kontaktfeder (7) zur Herstellung einer elektrischen Verbindung mit einem Anschluss des Bauelementes (1) auf. Darüber hinaus ist das Wandteil (4) mittels mindestens einer Verbindungsstruktur (21) mit dem Deckelbauteil (22) verbunden.

## Beschreibung

Die Erfindung betrifft ein Gehäuse für ein elektronisches Bauelement, insbesondere für ein Gunn-Element (Gunn-Oszillator) zur Erzeugung von Radarwellen, nach der Gattung des Hauptanspruchs.

### Stand der Technik

Für ein Abstandsradar bei Kraftfahrzeugen (ACC = "adaptive cruise control") werden Radarwellen mit Frequenzen oberhalb 50 Gigahertz eingesetzt, die mittels sogenannter Gunn-Elemente erzeugt werden.

Dazu wurde in der Anmeldung DE 198 56 332 A1 bereits vorgeschlagen, ein Gehäuse für ein derartiges Gunn-Element mit einem Bodenteil, einem Wandteil und einem Deckelteil zu realisieren, die das elektronische Bauelement umschließen. Dabei weist das Deckelteil eine Kontaktfeder zur Herstellung einer elektronischen Verbindung mit einem Anschluss des elektronischen Bauelementes auf, wobei Deckelteil und Kontaktfeder gemäß DE 198 56 332 A1 aus einem Stück ausgebildet sind.

Ein Gunn-Element in einem derartigen Gehäuse hat typischerweise einen Durchmesser von ca. 70 Mikrometer und eine Dicke von ca. 10 Mikrometer und ist sowohl auf der Oberseite wie auch auf der Unterseite elektrisch kontaktierbar.

Das Wandteil des Gehäuses gemäß DE 198 56 332 A 1 besteht aus Keramik. Die Verbindung des Wandteiles mit dem Deckelteil wird beispielsweise durch Kleben oder Löten realisiert.

### Vorteile der Erfindung

Das erfindungsgemäße Gehäuse für ein elektronisches Bauelement, insbesondere ein Gunn-Element, hat gegenüber dem Stand der Technik den Vorteil, dass das Wandteil aus Kunststoff unmittelbar nach der Herstellung des Deckelbauteils an dieses angespritzt werden kann. Dieses Anspritzen des Wandteiles in Spritzgusstechnik kann weiter sowohl an bereits vereinzelten Deckelbauteilen oder alternativ noch an mit einem zur Herstellung der Deckelbauteile benutzten Metallwafer oder Zwischenträger verbundenen Deckelbauteilen erfolgen. Insofern ist die Verbindung des Deckelbauteiles mit dem Wandteil vorteilhaft auch schon auf Wafer-Level im Vielfachnutzen herstellbar.

Durch die eingesetzte Spritzgusstechnik zur Verbindung des Wandteils aus Kunststoff mit dem Deckelbauteil mit Hilfe einer Verbindungsstruktur kann weiter vorteilhaft die mechanische Anbindung von Wandteil an Deckelbauteil an die jeweiligen Erfordernisse des Einzelfalles angepasst werden, so dass sichergestellt ist, dass die mechanisch auf das Gehäuse einwirkenden Kräfte stets derart aufgenommen bzw. abgeleitet werden, dass die Verbindung von Wandteil zu Deckelbauteil nicht zerstört wird.

Durch die Herstellung des Wandteiles aus Kunststoff und die Verbindungsstruktur zwischen Wandteil und Deckelbauteil ist weiter eine kostengünstige und mit geringen Fertigungstoleranzen behaftete Herstellung des Gehäuses für das elektronische Bauelement in Spritzgusstechnik auch in der Serienproduktion gewährleistet.

Schließlich ist vorteilhaft, dass durch die Verbindungsstruktur zwischen Wandteil und Deckelbauteil ein Montageschritt bei der Gehäusemontage eingespart wird, da beispielsweise auf ein Verlöten des Deckelbauteils mit dem Wandteil oder ein Verkleben verzichtet werden kann.

Insgesamt hat das erfindungsgemäße Gehäuse somit den Vorteil einer einfachen und zugleich sicheren Kontaktierung des elektronischen Bauelementes, so dass sich dieses Gehäuse vor allem für die Serienproduktion von Gunn-Elementen zur Erzeugung von Radarwellen in einem Abstandsradar in Kraftfahrzeugen eignet.

Vorteilhafte Weiterbildungen der Erfindung ergeben sich aus den in den Unteransprüchen genannten Maßnahmen.

So ist besonders vorteilhaft, wenn das Wandteil aus einem in Spritzgusstechnik verarbeitbaren Kunststoff besteht, der bis mindestens 120 Grad Celsius temperaturbeständig ist. Die Wahl von Kunststoff als Material für das Wandbauteil hat zudem den Vorteil, dass durch dessen Dielektrizitätskonstante die Resonanzfrequenz des Gunn-Elementes beeinflusst bzw. eingestellt werden kann.

Die Verbindungsstruktur zwischen Wandteil und Deckelbauteil ist vorteilhaft in Form einer Verzahnung von Deckelbauteil und Wandteil realisiert.

### Zeichnungen

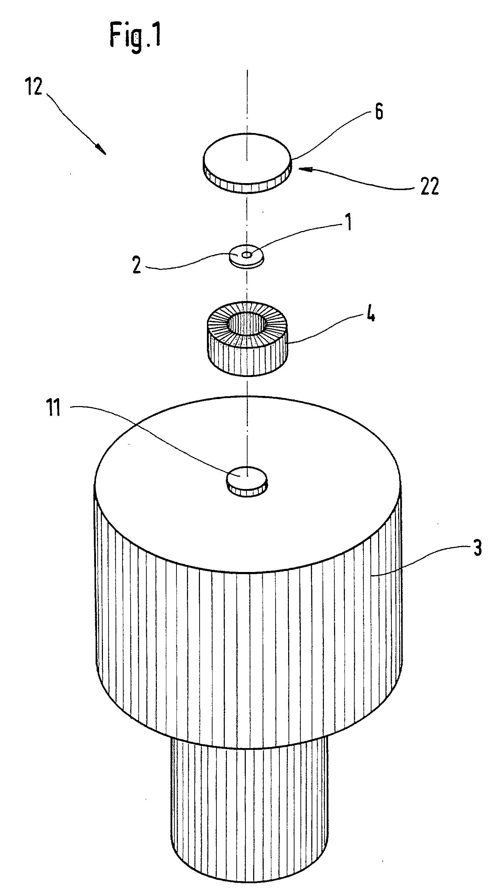

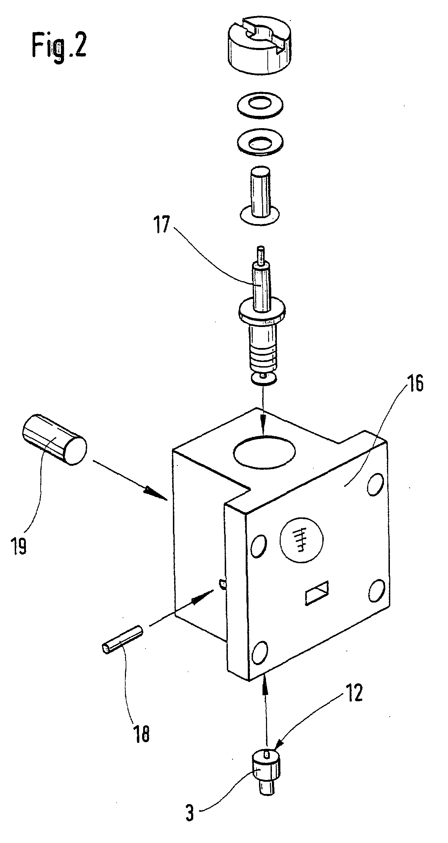

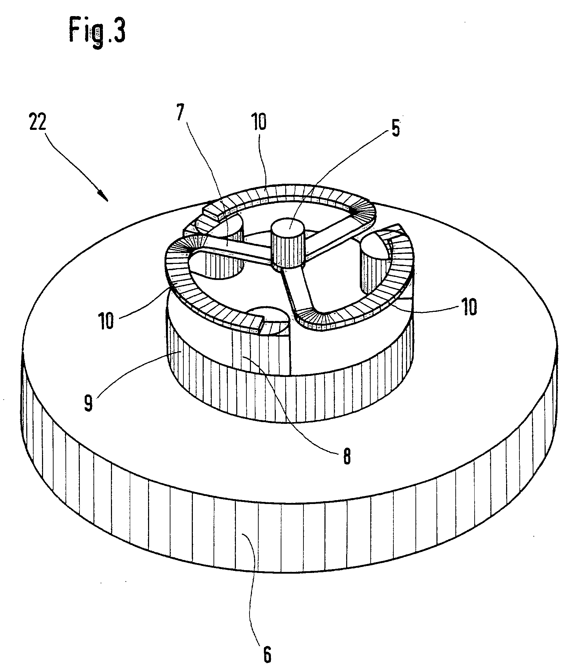

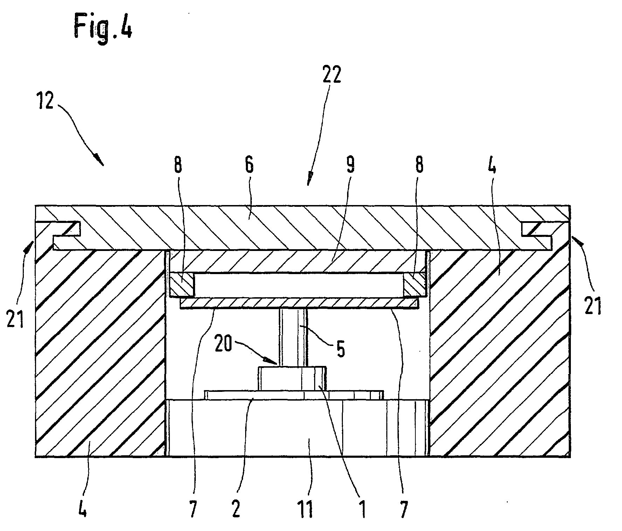

Die Erfindung wird anhand der Zeichnungen und in der nachfolgenden Beschreibung näher erläutert. Es zeigt Figur 1 ein Gehäuse für ein elektronisches Bauelement mit einem integrierten Bauelement, Figur 2 einen Gunn-Oszillator für ein Abstandsradar mit einem Gehäuse mit integriertem Bauelement gemäß Figur 1, Figur 3 ein Deckelbauteil gemäß Figur 1 und Figur 4 das Gehäuse mit integriertem Bauelement gemäß Figur 1 im Schnitt.

### Ausführungsbeispiele

Die Erfindung geht zunächst aus von einem Gehäuse für ein elektronisches Bauelement wie es in ähnlicher Form bereits aus der Anmeldung DE 198 56 332 A1 bekannt ist. Insbesondere sind aus dieser Anmeldung prinzipiell auch die Figuren 1 bis 3 bekannt, wobei jedoch das dort beschriebene Gehäuse für ein elektronisches Bauelement hinsichtlich des Materials des Wandteils 4 und hinsichtlich der Verbindung von Wandteil 4 mit Deckelbauteil 22 modifiziert worden ist.

Im Einzelnen zeigt Figur 1 ein Gehäuse 12 für ein elektronisches Bauelement 1, wobei das elektronische Bauelement 1 in Form eines Gunn-Elementes zur Erzeugung von Radarwellen ausgeführt ist. In Figur 1 ist weiter dargestellt, wie auf einem Bodenteil 3 aus Kupfer das Gehäuse 12 aufliegt. Das Bodenteil 3 dient dabei der Wärmeableitung und elektrischen Kontaktierung des elektronischen Bauelementes 1. Das Gehäuse 12 weist weiter eine Zentrierscheibe 11 aus leitfähigem Material auf, auf der das elektronische Bauelement 1 aufliegt. Dabei ist das elektronische Bauelement 1 mit der Zentrierscheibe 11 über eine Scheibe 2, einen sogenannten "Heat-Sink", aus Gold metallisch verbunden. Die Scheibe 2, die Zentrierscheibe 11 und das Bodenteil 3 dienen somit sowohl der Stromversorgung eines unteren Kontaktes des Bauelementes 1 als auch der Ableitung von Wärme. Weiter ist gemäß Figur 1 das Wandteil 4 in Form eines Kunststoffringes ausgeführt, der durch die Zentrierscheibe 11 zentriert wird. Verschlossen wird das Gehäuse 12 gemäß Figur 1 durch das Deckelbauteil 22, das einstückig ausgebildet ist, und das ein Deckelteil 6 in Form einer Scheibe aufweist.

Der typische Aufbau eines Gunn-Oszillators mit dem Bodenteil 3 und dem Gehäuse 12 mit integriertem Bauelement 1 gemäß Figur 1 ist in Figur 2 in Explosionsdarstellung dargestellt. Die Figur 2 zeigt dazu einen Oszillatorblock 16 mit integriertem Rechteckhohlleiter, in dem das Gehäuse 12 mit integriertem Bauelement 1 untergebracht, und mittels einer Gleichspannungszuführung 17 mit HF-Drosselscheibe und Resonatorscheibe kontaktiert ist. Weiter ist ein Frequenzabstimmstift 18 zur Frequenzabstimmung und ein Hohlleiterkurzschlussschieber 19 zur Leistungsregelung vorgesehen.

Die Figur 3 erläutert das Deckelbauteil 22 gemäß Figur 1 weiter im Detail. Im Einzelnen ist in Figur 3 dargestellt, dass das Deckelbauteil 22 auf seiner Innenseite einen Sokkelteil 9 in Form einer Scheibe aufweist, die mit dem Dekkelteil 6 verbunden ist. Weiter weist das Deckelbauteil 22 Säulen 8 auf, die mit dem Sockelteil 9 und Federarmen 10 verbunden sind. Die Federarme 10 bilden dabei eine Kontaktfeder 7, die in ihrem Zentrum einen Kontaktstempel 5 aufweist, der beispielsweise aus Gold ausgebildet ist. Dieser Kontaktstempel 5 dient der elektrischen Kontaktierung der Oberseite des elektronischen Bauelementes 1 gemäß Figur 1 bzw. Figur 4. Insbesondere sei dabei betont, dass das Dekkelbauteil 22 mit Deckelteil 6, Sockelteil 9, Säule 8, Kontaktfeder 7 und Kontaktstempel 5 aus einem Stück ausgebildet ist, so dass bei der Montage des Deckelbauteils 22 mit dem Wandteil 4 ein selbstjustierender Fügeprozess ermöglicht wird.

Hinsichtlich weiterer Details zur Herstellung und zu konstruktiven Einzelheiten des Deckelbauteils 22 sei auf die Anmeldung DE 198 56 332 A1 verwiesen.

Die Figur 4 zeigt das Gehäuse 12 mit integriertem Bauelement 1, das auf dem nicht dargestellten Bodenteil 3 gemäß Figur 1 angeordnet ist, im Schnitt. Dabei besteht das Wandteil 4 aus einem Ring aus einem in Spritzgusstechnik formbaren und verarbeitbaren Kunststoff, der bis mindestens 120° C temperaturbeständig ist. Die Auswahl dieses Kunststoffes erfolgt bevorzugt derart, dass dessen Dielektrizitätskonstante an die Frequenz der von dem Gunn-Element bzw. Bauelement 1 erzeugten Radarwellen angepasst ist.

Der Kunststoff zur Herstellung des Wandteils 4 ist beispielsweise PEI, TPX oder PC.

In Figur 4 ist weiter dargestellt, dass das elektronische Bauelement 1 auf seiner dem Kontaktstempel 5 zugewandten Oberseite eine Kontaktmetallisierung 20 aufweist, die einer Verbesserung des elektrischen Kontaktes dient. Schließlich zeigt Figur 4, dass das Wandteil 4 mit dem Deckelbauteil 22 über eine Verbindungsstruktur 21 verbunden ist. Diese Verbindungsstruktur 21 ist im erläuterten Ausführungsbeispiel in Form einer umlaufenden Verzahnung aufgeführt.

Die Verbindung von Wandteil 4 und Deckelbauteil 22 wird dadurch erreicht, dass das Wandteil 4 unmittelbar nach der Herstellung des Deckelbauteils 22 in Spritzgusstechnik an dieses angespritzt wird. Dieses Anspritzen kann dabei entweder an einen bereits vereinzelten Deckelbauteil 22 vorgenommen werden, oder alternativ durch Anspritzen von Wandteilen 4 an noch auf einem Metallwafer oder Zwischenträger befindliche Deckelbauteile 22.

Hinsichtlich weiterer Details zu Aufbau und Funktionsweise des Gehäuses 12, des Deckelbauteils 22 oder des elektronischen Bauelementes 1 in Form eines Gunn-Elementes sei auf die Anmeldung DE 198 56 332 A1 verwiesen.

## Patentansprüche

1. Gehäuse für ein elektronisches Bauelement, mit einem Bodenteil (3, 11), einem Wandteil (4) und einem Deckelbauteil (22), die das elektronische Bauelement (1) im Einbauzustand umschließen, wobei das Deckelbauteil (22) eine Kontaktfeder (7) zur Herstellung einer elektrischen Verbindung mit einem Anschluss des Bauelementes (1) aufweist, **dadurch gekennzeichnet, dass** das Wandteil (4) aus Kunststoff besteht und mittels mindestens einer Verbindungsstruktur (21) mit dem Deckelbauteil (22) verbunden ist.

2. Gehäuse nach Anspruch 1, **dadurch gekennzeichnet, dass** der Kunststoff ein in Spritzgusstechnik formbarer und verarbeitbarer Kunststoff ist.

3. Gehäuse nach Anspruch 1, **dadurch gekennzeichnet, dass** der Kunststoff bis mindestens 120°C temperaturbeständig ist.

4. Gehäuse nach Anspruch 1, **dadurch gekennzeichnet, dass** das elektronische Bauelement (1) ein Gunn-Element zur Erzeugung von Radarwellen ist.

5. Gehäuse nach Anspruch 4, **dadurch gekennzeichnet, dass** über die Dielektrizitätskonstante des Kunststoffes die Resonanzfrequenz des Gunn-Elementes beeinflussbar ist.

6. Gehäuse nach Anspruch 1, **dadurch gekennzeichnet, dass** die Verbindungsstruktur (21) eine Verzahnung von Deckelbauteil (22) und Wandteil (4) umfasst.

7. Gehäuse nach Anspruch 1, **dadurch gekennzeichnet, dass** das Wandteil (4) aus Kunststoff an das insbesondere einstückige Dekkelbauteil (22) angepritzt ist.
